Europäisches Patentamt

European Patent Office

Office européen des brevets

(11) Publication number: **0 304 142**
**A2**

# EUROPEAN PATENT APPLICATION

(21) Application number: 88302804.5

(22) Date of filing: 29.03.88

(51) Int. Cl.⁴: **H01L 23/08 , H01L 23/04**

Le titre de l'invention a été modifié (Directives relatives à l'examen pratiqué à l'OEB, A-III, 7.3)

(30) Priority: 05.08.87 JP 194389/87

(43) Date of publication of application:
**22.02.89 Bulletin 89/08**

(84) Designated Contracting States:
**DE FR GB**

(71) Applicant: **Director General, Agency of Industrial Science and Technology 1-3-1, Kasumigaseki Chiyoda-ku Tokyo 100(JP)**

(72) Inventor: **Hatta, Muneo c/o LSI Kenkyusho of Mitsubishi Denki K.K. 1, Mizuhara 4-chome Itami-City Hyogo Prefecture(JP)**
Inventor: **Kondo, Takashi c/o LSI Kenkyusho of Mitsubishi Denki K.K. 1, Mizuhara 4-chome Itami-City Hyogo Prefecture(JP)**
Inventor: **Shinoya, Yoshiyuki c/o LSI Kenkyusho of Mitsubishi Denki K.K. 1, Mizuhara 4-chome Itami-City Hyogo Prefecture(JP)**
Inventor: **Iwade, Shunei c/o LSI Kenkyusho of Mitsubishi Denki K.K. 1, Mizuhara 4-chome Itami-City Hyogo Prefecture(JP)**
Inventor: **Kimata, Masafumi c/o LSI Kenkyusho of Mitsubishi Denki K.K. 1, Mizuhara 4-chome Itami-City Hyogo Prefecture(JP)**
Inventor: **Denda, Masahiko c/o LSI Kenkyusho of Mitsubishi Denki K.K. 1, Mizuhara 4-chome Itami-City Hyogo Prefecture(JP)**

(74) Representative: **Lawson, David Glynne et al MARKS & CLERK 57-60 Lincoln's Inn Fields London WC2A 3LS(GB)**

(54) Package for semiconductor element.

(57) A semiconductor device comprising a silicon chip semiconductor element (1) and a package (2) including outer lead wires (3) for external connection. The package comprises a bottom plate (4) to which the semiconductor element (1) is bonded, a frame-shaped intermediate plate (7, 8) and a top plate (14) attached to the intermediate plate, theeby defining therein a closed space in which the semiconductor element (1) is mounted. The bottom plate (4) and the top plate (14) are made of a material which has substantially the same coefficie of thermal expansion as that of the semiconductor elemen (1).

FIG. 2

## SEMICONDUCTOR DEVICE

BACKGROUND OF THE INVENTION

This invention relates to a semiconductor device and more particularly to a packaged semiconductor device for use in very low temperatures.

In one application of a semiconductor infrared ray detector, the detector is used at cryogenic temperatures of liquid nitroge (-196°C). A silicon semiconductor element such as an IRCCD chip is bonded to a wall of a package including outer lead wires for external connection. The package comprises a bottom plate to which the semiconductor element is bonded and a frame-shaped intermediate plate attached to the bottom plate to form a side wall of the package. The intermediate plate and the bottom plate together define therein a semiconductor device receiving space in which the semiconductor device is mounted. In order to close the semiconductor device receiving space, a top wall is attached to the intermediate plate. While the semiconductor element is made of silicon, the bottom plate, the top plate and the intermediate plate constituting the package structure are made of alumina which has a coefficient of thermal expansion different from the silicon material.

Therefore, when the semiconductor infrared ray detector of this type is used in a cryogenic environment, the differences in thermal expansion between the semiconductor element and the other components causes both the semiconductor element and the top wall of the package to which the semiconductor element is bonded to be deformed. For example, with a linear type IRCCD silicon semiconductor element having a length of about 50 mm and bonded to the alumina package wall, the camber of the curved semiconductor element in the longitudinal direction is about 30 μm at room temperature (25°C) and about 100 μm at the temperature of liquid nitrogen (-196°C). This positional change of the surface of the semiconductor element due to the temperature change makes it impossible for the infrared rays emitted from the optical system coupled to the semiconductor device to be focused on the IRCCD surface, leading to a failure of the semiconductor device to function properly. This results in degrading of the reliability of the infrared ray detector.

SUMMARY OF THE INVENTION

Accordingly, an object of the present invention is to provide a semiconductor device which can be used within a very wide temperature range without degrading the reliability.

Another object of the present invention is to provide a semiconductor device which properly functions in a very wide temperature range.

A further object of the present invention is to provide a semiconductor device in which the distortion of the semiconductor element due to thermal expansion differences is eliminated.

With the above objects in view, the semiconductor device of the present invention comprises a silicon chip semiconductor element and a package including outer lead wires for external connection. The package comprises a bottom plate to which the semiconductor element is bonded, a frame-shaped intermediate plate and a top plate attached to the intermediate plate, thereby defining therein a closed space in which the semiconductor element is mounted. The bottom plate and the top plate are made of a material which has substantially the same coefficient of thermal expansion as that of the semiconductor element. Such material includes silicon carbide and aluminium nitride.

BRIEF DESCRIPTION OF THE DRAWINGS

The present invention will become more readily apparent from the following detailed description of preferred embodiments of the present invention shown by way of example in the accompanying drawings, in which:

Fig. 1 is a perspective view of the semiconductor device of the present invention; and

Fig. 2 is an exploded perspective view of the semiconductor device of the present invention shown in Fig. 1.

DESCRIPTION OF THE PREFERRED EMBODIMENTS

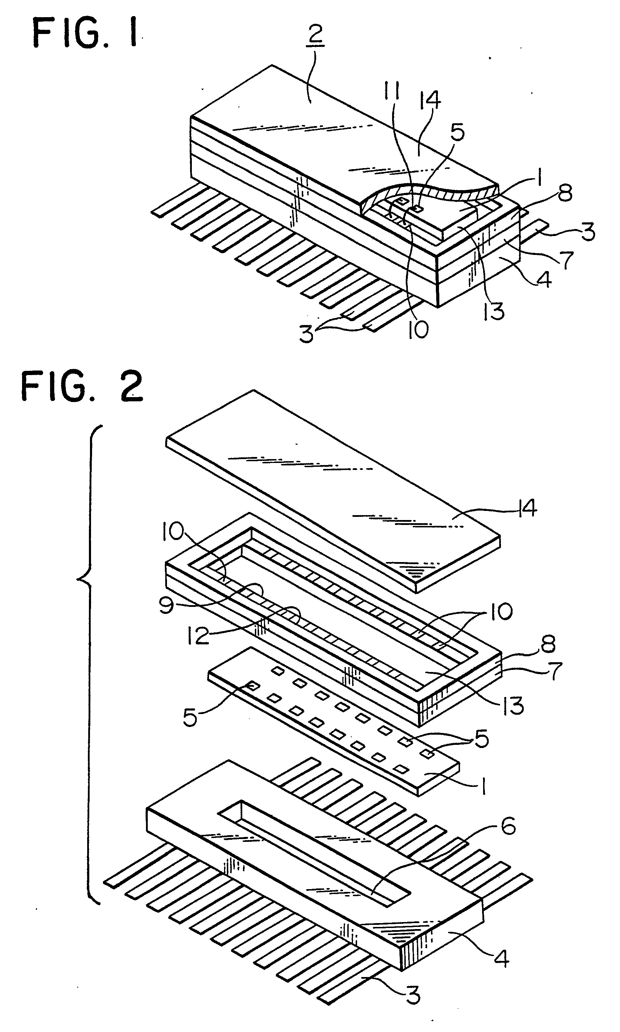

Fig. 1 illustrates the semiconductor device constructed in accordance with the present invention in perspective with a portion of it removed for clarity. Fig. 2 is an exploded perspective view of the semiconductor device shown in Fig. 1. The semicondcutor device illustrated in Figs. 1 and 2 is an infrared ray detector used in a cryogenic temperature such as that for liquid nitrogen (-196°C). The semiconductor device comprises a silicon semiconductor element 1 for detecting infrared rays such as an IRCCD chip and a package 2 for supporting and protecting the semiconductor element 1. The package 2 includes outer lead wires 3 for external connection.

As best seen from Fig. 2, the package 2 comprises a bottom plate 4 to which the semiconductor element 1 having a plurality of connecting pads 5 is bonded. The bottom plate 4 is a substantially rectangular plate with an elongated rectangular window 6 formed therein. The semiconductor element 1 is bonded at its periphery to the bottom plate 4 so that the central region of the back face (bottom surface in Figs. 1 and 2) of the semiconductor element 1 is exposed to the exterior through the window 6 when the element 1 is attached to the bottom plate. A plurality of outer lead wires 3 are provided on the bottom plate 4 for connecting the semiconductor element 1 on the bottom plate 4 to an external circuit (not shown).

According to the present invention, the bottom plate 4 is made of a material having a coefficient of thermal expansion similar to that of the semiconductor element 1. Thus, when the semiconductor element 1 to be bonded to the bottom plate 4 is made of silicon, bottom plate 4 is preferably made of silicon carbide or aluminium nitride which has a similar coefficient of thermal expansion.

The package 2 also comprises rectangular frame-shaped intermediate plates 7 and 8. The first intermediate plate 7 has an opening 9 within which the semiconductor element 1 is received. The first intermediate plate 7 is attached to the bottom plate 4 and has arrays of connecting pads 10 to which the pads 5 on the semiconductor element 1 are electrically connected by lead wires 11 (Fig. 1). Although not illustrated, the pads 10 on the first intermediate plate 7 are electrically connected to the outer leads 3 on the bottom plate 4 by a known arrangement when the first intermediate plate 7 is attached to the bottom plate 4.

The second intermediate plate 8 is bonded to the first intermediate plate 7 in a stacked relationship as shown in Fig. 2. The second intermediate plate 8 also has an opening 12 having a width larger than the opening 9 of the first intermediate plate 7, so that the arrays of the pads 10 on the first intermediate layer 7 are exposed in the opening 12 of the second intermediate plate 8, enabling the lead wires 11 to be connected between the pads 5 and 10 as best shown in Fig. 1. Thus, when the first and the second intermediate plates 7 and 8 are bonded and when these plates 7 and 8 are attached to the bottom plate 4, these three plates 4, 7 and 8 together form a closed side wall which defines therein a semiconductor element receiving space 13 in which the semiconductor element 1 is accomodated. In the illustrated embodiment, the first and the second intermediate plates 7 and 8 are made of alumina.

The package 2 of the semiconductor device of the present invention further comprises a rectangular top plate 14 attached to the second intermediate plate 8 so that the semiconductor device receiving space 13 defined by the first and the second intermediate plates 7 and 8 is closed.

According to the present invention, the top plate 14 is made of a material having substantially the same coefficient of thermal expansion as those of the semiconductor element 1 and the bottom plate 4. Thus, when the silicon semiconductor element 1 is used, the top plate 14 is also preferably made of silicon carbide or aluminium nitride which has a similar coefficient of thermal expansion.

The semiconductor infrared ray detector as above described receives infrared rays to be measured at the back face (bottom surface) of the semiconductor element 1 in Figs. 1 and 2 through the detecting window 6 in the bottom plate 4. The infrared rays reach the pixels (not shown) on the upper surface of the IRCCD element 1, where the infrared rays are converted into electrical signals which are supplied to the external circuit (not shown) through the pads 5 on the upper surface of the element 1, the lead wires 11, the connecting pads 10 on the first intermediate plate 7, internal connections (not shown) within the first intermediate plate 7 and the bottom plate 4, and finally through the outer leads 3.

Since the semiconductor device is cooled to a cryogenic temperature during infrared ray detection, it deforms due to the thermal expansion differences between the various components constituting the semiconductor device.

However, since tha package 2 of the semiconductor device of the present invention has the bottom plate 4 and the top plate 14 which are made of materials having coefficients of thermal expansion equal or similar to each other, the thermal expansion or contraction of the bottom plate 4 and the top plate 14 due to temperature changes are substantially equal. Therefore, substantially no thermal deformation or bend occurs in the package 2 of the semiconductor device even when the semiconductor device is subjected to a very wide temperature change of from room temperature (25 °C) to the temperature of liquid nitrogen (-196 °C).

Accordingly, the semiconductor device of the present invention properly functions within a very wide temperature range without a degradation in reliability. Also, the distortion of the semiconductor element 1 in the semiconductor device due to the thermal expansion differences is reduced and the problem of defocusing is significantly moderated.

## Claims

1. A semiconductor device comprising a silicon semiconductor element and a package including outer lead wires said package comprising: a bottom plate to which said semiconductor element is bonded; a frame-shaped intermediate plate attached to said bottom plate to form a side wall which defines therein a semiconductor device receiving space in which said semiconductor device is mounted on said bottom plate; and a top plate attached to said intermediate plate to close said semiconductor device receiving space; said bottom plate and said top plate being made of a material having substantially the same coefficient of thermal expansion as that of the semiconductor element.

2. A semiconductor device as claimed in claim 1, wherein at least one of said top plate and said bottom plate is made of a material selected from a group of silicon carbide and aluminium nitride.

3. A semiconductor device as claimed in claim 1, wherein said intermediate plate is made of alumina.

4. A semiconductor device substantially as hereinbefore described with reference to Figures 1 and 2 of the accompanying drawings.

EP 0 304 142 A2

# FIG. 1

# FIG. 2